# DEMANDE DE BREVET EUROPEEN

(11) **EP 1 387 304 A1**
(43) Date de publication de la demande: **04.02.2004**
(21) Numéro de dépôt: 03291871.6
(22) Date de dépôt: 29.07.2003
(51) Int. Cl.: G06F 17/50

(54) **Procédé de vérification fonctionnelle d'un modèle de circuit intégré pour constituer une plate-forme de vérification, équipement émulateur et plate-forme de vérification**

(30) Priorité: 30.07.2002 FR 0209691
(71) Demandeur: Bull S.A., 78340 Les Clayes Sous Bois (FR)
(72) Inventeur: Kaszynski, Anne, Mainguérin, 78660 Ablis (FR); Abily, Jacques, 78370 Plaisir (FR)
(74) Mandataire: Debay, Yves

(57) **Abrégé**

La présente invention concerne un procédé de vérification fonctionnelle d'un modèle logiciel (40) d'un circuit intégré à la demande (ASIC), en langage de bas niveau (tel que par exemple de type HDL) traitant de façon séparée l'établissement du modèle et la mise au point des tests de vérification fonctionnelle à appliquer au modèle du circuit pour constituer une plate-forme de vérification comportant les deux étapes suivantes :
- constitution d'un émulateur autonome (1) de circuit obtenu en remplaçant le modèle en langage de bas niveau (de type HDL) de description physique du circuit en projet à valider, par une description abstraite de haut niveau (par exemple C⁺⁺) générant des structures de données de réponse conformes à la spécification fonctionnelle (20) du projet en fonction des stimuli reçus, ce mode étant dit « mode émission »,
- intégration du modèle logiciel (40) en langage de bas niveau (de type HDL) du circuit résultant du projet dans une plate-forme de vérification, et constitution du branchement de l'émulateur autonome (1) de circuit, précédemment validée, en parallèle sur les interfaces du modèle logiciel (40) du circuit, et du branchement d'un émulateur d'environnement (11, 21, 22), et
- utilisation de cette plate-forme comme référence pour la validation des données de réponses émises par le modèle logiciel (40) du circuit, ce mode étant dit « mode vérification ».

## Description

La présente invention concerne un procédé de vérification fonctionnelle d'un modèle logiciel d'un circuit intégré pour constituer une plate-forme de vérification et la plate-forme de vérification ainsi constituée.

L'invention s'applique, d'une part, lors de la phase de vérification de la conception des spécifications particulières d'un circuit intégré répondant aux besoins d'un industriel utilisateur, usuellement appelé ASIC (Application Specific Integrated Circuit), mais, également, dans la phase de mise au point de l'ensemble constitué par le composant physique ASIC et le programme d'application exécuté par l'ASIC composant physique.

Dans le domaine des circuits intégrés, il existe deux types de circuits, les circuits dits classiques et les circuits spécifiques dits ASICs. Les fabricants de circuits intégrés classiques présentent des catalogues de circuits standards dont les références désignent chacune une fonction particulière normalisée. Pour des applications spécifiques, l'industriel utilisateur de circuits intégrés préfère faire développer des circuits spécifiques dits ASICs.

Les différentes étapes de développement des ASICs sont les suivantes :
- définition d'une spécification fonctionnelle ;
- modélisation (définie ci-après) en un langage de type HDL de description matérielle de l'ASIC et vérification fonctionnelle de la conception associée à cette modélisation ;
- fabrication technologique par le fondeur de circuits intégrés ; et
- mise au point matérielle du circuit.

La définition de la spécification fonctionnelle est : l'élaboration des documents décrivant les fonctionnalités couvertes par l'ASIC.

Elle comprend :
- d'une part, les spécifications de niveau système décrivant :
   - la visibilité fonctionnelle des registres de l'ASIC ;
   - le protocole de cohérence assurant l'intégrité des données, dans le cas d'un système à mémoire partagée ;
   - les spécifications des interfaces externes des composants ;
- et, d'autre part, les spécifications décrivant les choix d'implémentation de l'ASIC.

La modélisation de type HDL de l'ASIC consiste en la description des équations logiques booléennes rendant compte de son comportement conformément à sa spécification. Le langage de type HDL utilisé est un langage dédié à la description des objets matériels du circuit intégré (Hardware). Il contient les primitives de description des composants avec leurs signaux d'interface ainsi que des éléments mémorisant, tels que registres ou mémoires.

Le niveau de description de type HDL sert de point d'entrée au processus de génération automatique aboutissant in fine à la fourniture de masques pour le processus technologique de fabrication du circuit.

La vérification fonctionnelle de la conception de l'ASIC a pour objectif de vérifier la conformité du comportement du modèle de type HDL de l'ASIC à sa spécification fonctionnelle en amont du lancement du processus technologique.

Une fois la logique de l'ASIC stabilisée, un processus quasi-automatique appliqué à la description de type HDL de l'ASIC permet de générer la liste des cellules physiques constituant l'ASIC et d'élaborer les masques livrés au fondeur (fabricant d'ASIC) pour la fabrication du circuit.

La fabrication technologique du circuit est le processus chimique permettant, à partir des masques, de produire les échantillons physiques des circuits.

Des tests non fonctionnels sont appliqués en sortie de fabrication pour valider que le processus technologique s'est bien déroulé, et sélectionner les échantillons bons candidats à être montés dans les boîtiers pour la phase suivante de validation.

La mise au point matérielle est la première phase de validation des ASICs dans leur environnement système réel après montage des échantillons dans les boîtiers et connexion sur les cartes.

Au stade de la fabrication, le fabricant d'ASIC n'est pas en mesure de vérifier que le modèle fonctionnel de l'ASIC fourni par l'industriel utilisateur ne comportait pas d'erreur de conception. Il est simplement en mesure de confirmer la conformité de la puce de silicium avec le schéma fonctionnel demandé.

Un des buts de l'invention est de permettre à l'industriel utilisateur de l'ASIC, avant la réalisation physique du circuit, de vérifier l'exactitude du modèle fonctionnel qu'il va fournir au fondeur (fabricant d'ASIC).

Compte tenu du coût élevé d'étude de l'ASIC, il faut valider le plus complètement possible le schéma théorique résultant de la spécification fonctionnelle pour éliminer toute erreur subsistante avant de lancer l'étude du dossier de fabrication de l'ASIC par le fondeur. C'est pourquoi le niveau de description du modèle de l'ASIC est utilisé pour la vérification fonctionnelle de la conception de l'ASIC en amont du lancement du processus technologique de fabrication. La vérification a pour objectif de vérifier la conformité du comportement du modèle de type HDL de l'ASIC à sa spécification fonctionnelle.

Avec la complexité croissante des ASICs liée à leur haut degré d'intégration et le coût élevé de leur fabrication, la vérification fonctionnelle pendant la phase de conception du circuit occupe une place prépondérante (plus de 60%) qui tendra à s'accroître encore de façon notable dans les années à venir.

D'où la nécessité de disposer d'une méthodologie solide de vérification fonctionnelle.

C'est dans ce contexte que se situe l'un des intérêts de l'invention proposée.

Lorsque des échantillons de l'ASIC composant physique ont été fabriqués, l'industriel utilisateur valide la fonctionnalité de l'ensemble ASIC composant physique-programme d'application exécuté par l'ASIC et vérifie qu'ils répondent au cahier des charges de l'ensemble. Au cours de cette phase, les ASICs montés dans leurs boîtiers sont connectés sur leur carte à leur environnement système réel pour constituer une plate-forme de validation.

L'invention proposée peut également trouver son application dans cette phase.

Pour vérifier fonctionnellement les diverses parties constitutives du modèle de l'ASIC, telles qu'unité arithmétique, mémoires, compteurs, logique combinatoire, routeur à antémémoire et autres, on peut les activer séparément, dans la mesure où chacune est directement accessible depuis les entrées/sorties simulées de l'ASIC et suffisamment indépendante des autres. On vérifie alors que la partie considérée est conforme à un modèle de fonctionnement logique défini au cahier des charges. Il faut aussi vérifier l'interfonctionnement des diverses parties, en activant simultanément plusieurs de ces parties. Il faut en particulier effectuer des tests combinatoires entre les parties pour tenter de vérifier l'absence de configurations, non prévues lors de la conception du modèle fonctionnel, d'états des diverses parties respectives, qui seraient susceptibles de conduire à un fonctionnement défectueux, par exemple un blocage mutuel entre deux parties. Il est aisé de comprendre que le nombre des tests combinatoires croît donc beaucoup plus rapidement que le nombre de circuits ou transistors de l'ASIC. En outre, la présence de mémoires dans l'ASIC, qui peuvent commander certains des circuits de celui-ci, entraîne le fait que l'état global des diverses sorties, pour des entrées présentant un même état global à un instant déterminé, dépend de l'historique de la succession des états d'entrée précédents.

La mise au point de la programmation de tests fonctionnels est longue et coûteuse. En pratique, cette mise au point s'effectue en utilisant le modèle de l'ASIC. En d'autres termes, dès que le modèle est conçu, on peut alors chercher à détecter les deux types d'erreurs suivants : les erreurs résiduelles du cahier des charges, et les erreurs ou lacunes des programmes de validation fonctionnelle de l'ASIC ou des programmes applicatifs. Ce cumul de tâches réagissant les unes sur les autres, est évidemment lourd à gérer, et il entraîne des coûts et des retards.

La présente invention vise à limiter un ou plusieurs de ces inconvénients.

A cet effet, l'invention concerne tout d'abord un procédé de vérification fonctionnelle d'un modèle logiciel d'un circuit intégré à la demande (ASIC), en langage de bas niveau (tel que par exemple de type HDL) traitant de façon séparée l'établissement du modèle et la mise au point des tests de vérification fonctionnelle à appliquer au modèle du circuit pour constituer une plate-forme de vérification comportant les deux étapes suivantes :
- constitution d'un émulateur autonome de circuit obtenu en remplaçant le modèle en langage de bas niveau (de type HDL) de description physique du circuit en projet à valider, par une description abstraite de haut niveau (par exemple C⁺⁺) générant des structures de données de réponse conformes à la spécification fonctionnelle du projet en fonction des stimuli reçus, ce mode étant dit « mode émission »,
- intégration du modèle logiciel en langage de bas niveau (de type HDL) du circuit résultant du projet dans la plate-forme de vérification, et branchement de la configuration de simulation autonome, précédemment validée, en parallèle sur les interfaces du modèle logiciel du circuit, et du branchement d'un émulateur d'environnement, et
- utilisation de plate-forme comme référence pour la validation des données de réponses émises par le modèle logiciel du circuit, ce mode étant dit « mode vérification ».

Le programme de validation de fonctionnalité peut ainsi être mis au point en temps masqué, en parallèle avec l'élaboration du dossier de fabrication de l'ASIC. Ensuite, un modèle de ce dernier ayant été élaboré, il suffit de disposer en mémoire de la séquence d'entrée de test de validation de fonctionnalité, puisque l'émulateur représente la spécification fonctionnelle et fournit les stimuli de sortie en réponse à cette séquence d'entrée, à titre de référence.

L'émulateur constitue ainsi, fonctionnellement, une sorte de bibliothèque qui contiendrait tous les états de sortie possibles du modèle de l'ASIC, prédits d'après les réponses de la spécification fonctionnelle à tous les stimuli d'entrée possibles fournis par un émulateur d'environnement. La fourniture de stimuli d'entrée par l'émulateur d'environnement équivaut à un adressage du contenu de la bibliothèque pour sélectionner l'état ou stimuli de sortie correspondant prédit. Cette bibliothèque pourrait donc être une simple mémoire, constituant une table de décision contenant la totalité des états de sortie prédits, adressée pour décider que l'un de ses états est celui qui convient. Toutefois, la taille mémoire nécessaire serait en général excessive, et il est alors préférable d'élaborer en temps réel la prédiction des stimuli de sortie, d'après la spécification fonctionnelle.

Il est à noter que le procédé de l'invention n'est pas limité à des ASICs purement numériques, car on peut émuler des circuits analogiques, le cas échéant, au moyen d'une unité de calcul numérique et d'un convertisseur numérique / analogique.

Dans un mode de mise en oeuvre, un utilisateur élabore, au moyen d'un système de traitement de données, la configuration de simulation autonome correspondant au modèle logiciel de l'ASIC au moyen de la spécification fonctionnelle,
- l'utilisateur écrit, à partir de la spécification fonctionnelle, et mémorise, dans une plate-forme de test de modèles de circuits intégrés, un programme de test du modèle de l'ASIC, comportant des séquences de stimuli d'entrée à fournir au modèle logiciel de l'ASIC, auxquelles la configuration de simulation autonome fait correspondre, en fonction de la spécification fonctionnelle, des séquences de stimuli de sortie,
- l'utilisateur relie ensemble, et active, la configuration de simulation autonome et la plate-forme de test, et
- il observe les stimuli de sortie du modèle de type HDL de l'ASIC pour valider fonctionnellement l'ensemble constitué par le modèle logiciel du circuit ASIC et le programme de test de validation, et ainsi valider le modèle logiciel par rapport à la spécification fonctionnelle.

Avantageusement, la configuration de simulation autonome communiquant avec l'utilisateur pour commander l'activation de modèles, préalablement établis et mémorisés, de séquences de stimuli d'entrée définis dans un langage de programmation de haut niveau, et commande l'activation de programmes associés de validation progressive de séquences de test déterminées à partir des modèles.

Grâce à la modularité du système et à la progressivité de la mise au point, l'utilisateur peut ainsi s'appuyer, au départ, sur des modèles de test de validation fonctionnelle existants, a priori au point, qu'il complète ou adapte au cas particulier de l'ASIC.

L'utilisateur peut écrire et fournir la spécification fonctionnelle dans un langage de programmation de bas niveau, spécifiant des modèles fonctionnels de circuits.

Il peut aussi, dans un mode mixte, fournir la spécification fonctionnelle sous la forme d'un programme en langage de bas niveau, de modèles (de type HDL) fonctionnels de circuits, et d'un programme en langage de haut niveau, de modèles fonctionnels ((C⁺⁺) symboliques de circuits), et commander la configuration de simulation autonome (1) pour effectuer une co-simulation par synchronisation d'exécution des deux programmes de spécification.

Les diverses parties de la spécification fonctionnelle peuvent ainsi être écrites dans le langage qui convient le mieux, et en particulier qui évite les pertes de temps pour définir les stimuli de sortie.

Avantageusement, la plate-forme de test vérifie que les réponses du modèle logiciel de l'ASIC sont situées dans des plages de temps de réponse spécifiées dans la spécification fonctionnelle.

L'invention concerne aussi une plate-forme de vérification de modèle logiciel de circuit intégré à la demande, caractérisé par le fait qu'elle comporte des moyens de traitement de données permettant à un client de sélectionner des modèles de test engendrant des stimuli d'entrée de l'ASIC, ces moyens de traitement étant agencés pour lire des éléments de spécification fonctionnelle de l'ASIC, et comportant des programmes agencés pour élaborer un programme de test de validation fonctionnelle constitué de stimuli de sortie à partir des stimuli d'entrée et des éléments de spécification fonctionnelle.

Avantageusement, la plate-forme de vérification comporte une bibliothèque de modèles fonctionnels de blocs de circuits pour ASIC et des moyens de sélection des modèles par un fichier de définition de la configuration, pour constituer un modèle correspondant à la spécification fonctionnelle de l'ASIC intégré à la définition de son environnement.

Il peut y être prévu, dans une liaison le reliant au client, deux circuits en série d'adaptation de langage de programmation agencés pour transformer des commandes en langage de haut niveau (C⁺⁺), utilisé par le client, en commandes en langage de bas niveau (de type HDL), exploitables par le modèle de l'ASIC, et pour, respectivement, retransformer les commandes en langage de bas niveau en commande en langage de haut niveau.

Avantageusement, la plate-forme de vérification comporte des moyens d'exécuter ses traitements en même temps que la simulation qu'elle peut interrompre dès la détection d'une erreur au moment même de l'apparition de l'erreur.

Selon une autre particularité, les éléments de spécification fonctionnelle sont constitués d'une table de vérité, ou de comportement, correspondant aux fonctions des diverses parties ou divers éléments de circuit fonctionnels du modèle logiciel de l'ASIC, et des plages de retard de propagation à respecter entre chaque entrée et chaque sortie.

Selon une autre particularité, la plate-forme de vérification dispose d'une antémémoire pour mémoriser les blocs utilisés par les noeuds d'après leur adresse et des moyens de gérer, pour une adresse utilisée par un ou plusieurs noeuds, un vecteur de présence avec un témoin de présence par noeud.

Selon une autre particularité, les programmes sont orientés objet et l'émulateur est structuré en un ensemble de classes permettant de gérer une collection d'hypothèses d'exécution d'une transaction sur un bloc mémoire du modèle logiciel, et de gérer également les transactions en collisions, c'est-à-dire utilisant un même bloc mémoire.

Selon une autre particularité, les algorithmes des programmes de l'émulateur réalisent les fonctions suivantes : génération des prédictions, d'élimination des prédictions, ré-ajustement de mauvaise prédiction, réduction du nombre d'hypothèses valides et terminaison de collisions.

Selon une autre particularité, la plate-forme de vérification est utilisée en émulateur de circuit routeur, de circuit à antémémoire ou de circuit routeur à antémémoire.

Selon une autre particularité, la plate-forme de vérification permet de tester un modèle logiciel de circuit intégré à la demande (ASIC), caractérisée en ce qu'elle comporte un émulateur d'ASIC pour commander un comparateur prévu pour recevoir des valeurs générées par le modèle logiciel de circuit ASIC testé, sur réception de stimuli envoyés par au moins un circuit générateur de stimuli, mémorisant le programme de test, une interface de traduction des stimuli d'un langage élaboré vers un langage de bas niveau correspondant à celui du modèle logiciel, et des moyens de validation de la vérification en cas de détection de collision par le comparateur.

Dans une forme de réalisation, les moyens de sélection de la réponse à des stimuli dépendants de la constitution des circuits testés sont constitués d'un modèle élaboré grâce à des moyens de sélection, parmi une bibliothèque, de modèles fonctionnels associant, à chacun des modèles, les réponses à un stimulus donné, le modèle correspondant à la constitution du circuit à tester.

La plate-forme peut comporter des moyens de mémorisation des réponses ainsi sélectionnées pour constituer un modèle de test à appliquer au circuit testé lors de la réception de stimuli.

Selon une autre particularité, chaque transaction est constituée, au niveau de chaque interface, d'un paquet requête et d'un ou plusieurs paquets réponses associés, dont les valeurs des paramètres et/ou les contraintes temporelles d'émission des paquets peuvent être forcées à partir du programme de test fonctionnel exécuté par l'émulateur de l'environnement, qui traduit de façon adéquate l'ensemble de ces paramètres lors de l'émission des paquets aux bornes du modèle logiciel du projet.

Selon une autre particularité, la génération des prédictions est effectuée par l'émulateur du circuit sans avoir à prélever d'informations supplémentaires sur le fonctionnement interne du circuit en projet.

L'invention sera mieux comprise à l'aide de la description suivante d'un mode de réalisation de l'invention et de mise en oeuvre du procédé de l'invention, en référence au dessin annexé, sur lequel :
- la figure 1 est un diagramme fonctionnel représentant un émulateur de circuit intégré ASIC représenté avec la gestion d'une interface dans un émulateur d'environnement pouvant comporter une ou plusieurs interfaces,
- la figure 2 représente le même émulateur, branché logiquement en parallèle sur le modèle logiciel de circuit ASIC à tester, ou émulateur du circuit en projet en mode émetteur, représenté avec la gestion d'une interface dans un émulateur d'environnement pouvant comporter une ou plusieurs interfaces,
- la figure 3 est une variante de la figure 2 appliquée à un modèle de circuit à deux noeuds, et
- la figure 4 représente l'architecture interne d'un vérificateur.

Avant de décrire l'invention il est nécessaire, pour sa bonne compréhension, de poser un certain nombre de définitions utilisées par la suite.

Un émulateur est un programme ou un dispositif permettant de reproduire sur ses interfaces externes le même fonctionnement que le(s) circuit(s) ou modèles de type HDL de circuit au(x)quel(s) il se substitue.

Dans ce document, l'invention est appliquée au cas d'un circuit intégré de type routeur avec antémémoire car reconnu comme étant le cas le plus complexe. Dans la suite, le mot ROUTEUR désigne :
- soit le modèle de type HDL du circuit en projet,
- soit l'émulateur du circuit en projet ("Design") en mode émission.

La programmation objet a permis : d'une part, de structurer l'émulateur de ROUTEUR en un ensemble de classes spécialisées, d'autre part, de simplifier le traitement par la localisation et la spécialisation de ces traitements à chaque instance de chaque classe, comme nous le verrons par la suite.

Dans le contexte de la simulation logicielle ("Software"), la plate-forme de vérification est constituée de l'ensemble des modèles de génération de stimuli et des modèles d'observations aux interfaces du circuit en projet ou en conception ("Design") qui est à valider. Ces modèles d'observations constituent un émulateur de l'environnement du circuit en projet ("Design").

La méthodologie de vérification de la plate-forme de l'invention fait également usage d'un émulateur du projet ("Design") pouvant fonctionner suivant 2 modes :
- Le mode contrôleur ("Checker") dans lequel l'émulateur du circuit en projet ("Design") sert de référence pour la validation des réponses du circuit en projet ("Design") en fonction des stimuli d'entrée appliqués par l'émulateur d'environnement, ou des réponses de l'émulateur du circuit en projet en mode émetteur.
- Le mode émetteur dans lequel l'émulateur du circuit en projet ("Design)" se substitue au projet ("Design") lui-même dans des configurations de simulation autonomes pour la mise au point de la plate-forme de vérification sans avoir à utiliser le modèle de type HDL du projet ("Design").

L'ensemble des émulateurs (émulateur de circuit et émulateur d'environnement) constituant la plate-forme de vérification sont des modèles objet écrits en C⁺⁺ connectés aux interfaces du modèle en langage de type HDL de bas niveau du circuit en projet ("Design") via des adaptateurs d'interface en type HDL. Le degré d'utilisation du langage évolué par rapport au degré d'utilisation du langage de bas niveau type HDL varie selon l'état d'avancement de mise au point des émulateurs.

En général, on part d'une spécification fonctionnelle de circuit contenant une majorité de langage C⁺⁺ et juste des interfaces en langage de type HDL pour aboutir à un modèle logiciel comportant une majorité de langage de type HDL de bas niveau et quelques interfaces en C⁺⁺. L'évolution du modèle logiciel en langage de type HDL du circuit en cours de développement se fait progressivement en utilisant des modèles intermédiaires mis au point contenant une proportion plus équilibrée de langage évolué par rapport à la proportion de langage de type HDL.

Dans les adaptateurs d'interface, les échanges entre C⁺⁺ et de type HDL sont abstraits en événements. Les événements rendent aussi bien compte des échanges arbitraires de données contenues dans les paquets que des changements de valeurs sur les signaux de contrôle. Le paquet est la granularité de traitement atomique des modèles abstraits C⁺⁺ appartenant au niveau de description (dit protocole) des interfaces.

En mode contrôleur ("Checker"), l'émulateur du circuit en projet ("Design") effectue ses contrôles en temps réel, c'est-à-dire que ses traitements s'exécutent en même temps que la simulation qu'il peut interrompre dès la détection d'une erreur au moment même de son apparition. Cette caractéristique intéressante du point de vue exploitation permet d'éviter de générer des fichiers de trace pendant l'exploitation normale et de générer les informations nécessaires au diagnostique que lorsqu'il y a erreur, limitant ainsi la lourdeur des traitements postérieurs dits de post-processing.

En mode contrôleur ("Checker"), l'émulateur du circuit en projet ("Design") peut construire ses contrôles sur la seule base des spécifications fonctionnelles de niveau système sans prélèvement d'informations supplémentaires sur le fonctionnement interne du circuit en projet ("Design"). Cette propriété remarquable permet son application à 2 types de contextes différents :
- Le contexte de simulation C⁺⁺/HDL du circuit en projet ("Design"), dans lequel l'émulateur du circuit en projet ("Design") est alors connecté à l'ensemble des interfaces du modèle logiciel en langage de type HDL de bas niveau du circuit en projet ("Design"), sur lesquels il prélève les échanges de paquets des modèles d'observations via les adaptateurs d'interface ;
- En exécution C⁺⁺ seule, à partir de traces prélevées aux interfaces du modèle logiciel du circuit en projet ("Design"), ces traces étant éventuellement reformatées sous forme de paquets avant d'être rejouées en autonome par l'émulateur du circuit en projet ("Design").

Les traces prélevées aux bornes du circuit en projet ("Design") à valider peuvent être d'origines différentes :
- Dans le contexte de la vérification fonctionnelle, elles proviennent de la mémorisation des paquets échangés au cours d'une simulation antérieure. Les traces peuvent se présenter, soit sous forme textuelle, soit sous forme de structures C⁺⁺ dites fibres stockées dans une base.
- Dans le contexte de la mise au point matérielle, elles proviennent du prélèvement des stimuli aux bornes de l'échantillon physique du circuit. Les stimuli abstraits en événements sont reformatés sous forme de paquets avant d'être injectés à l'émulateur du projet ("Design)" pour diagnostic en exécution autonome.

Les tests fonctionnels commandent le paramétrage des paquets transmis au projet ("Design") cible via son environnement :
- Dans le contexte de la vérification fonctionnelle, les tests fonctionnels s'appuient sur l'interface programmatique applicative (API) de l'émulateur de l'environnement du circuit en projet ("Design) à valider pour commander directement et précisément la succession des transactions à transmettre au projet pour exécution. Chaque transaction est constituée au niveau de chaque interface, d'un paquet requête et d'un ou plusieurs paquets réponses associés. Aussi bien les valeurs des paramètres que les contraintes temporelles d'émission des paquets peuvent être forcées à partir des tests. L'émulateur de l'environnement traduit de façon adéquate l'ensemble de ces paramètres lors de l'émission des paquets aux bornes du projet ("Design").
- Dans ce contexte, les tests fonctionnels ont également la possibilité de forcer, dans chaque composant du système, et en conformité avec le protocole de cohérence assurant l'intégrité des données dans le système, les états de départ des adresses des blocs accédés. Cette facilité permet de créer de façon contrôlée des situations de cohérence très diversifiées et complexes sans avoir à reconstituer un historique d'exécution permettant d'aboutir à ces situations.
- Dans le contexte de la mise au point matérielle, l'exécution des tests fonctionnels se fait en situation réelle sur les processeurs du système, celui-ci incluant les échantillons physiques du circuit à valider. Les tests fonctionnels décrivent des programmes traduits en suite d'instructions à faire exécuter par les processeurs du système qui les traduiront eux-mêmes, si besoin est, en transactions adressées au système tout entier.
- Dans ce contexte, les espaces d'adresses sont typés. Aucun forçage direct sur le format des transactions ou l'état des blocs accédés n'est possible.

A cause de leur nature différente, il est impossible de reconduire en situation réelle sur les échantillons physiques, dans le contexte de mise au point, les tests fonctionnels préalablement élaborés dans le contexte de la vérification fonctionnelle et appliqués via l'émulateur de l'environnement sur le modèle de type HDL du circuit en projet ("Design") pour la vérification de sa conception avant sa réalisation physique.

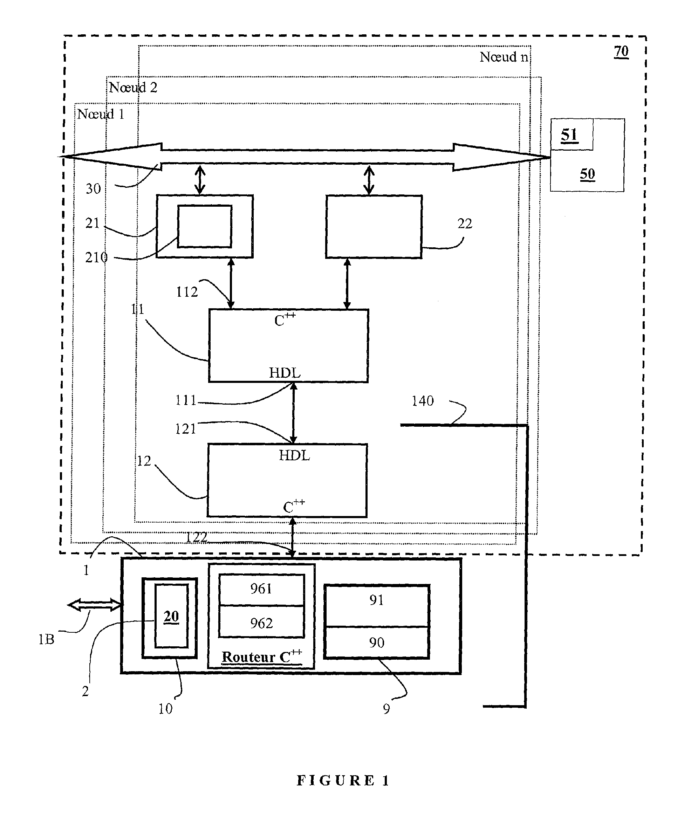

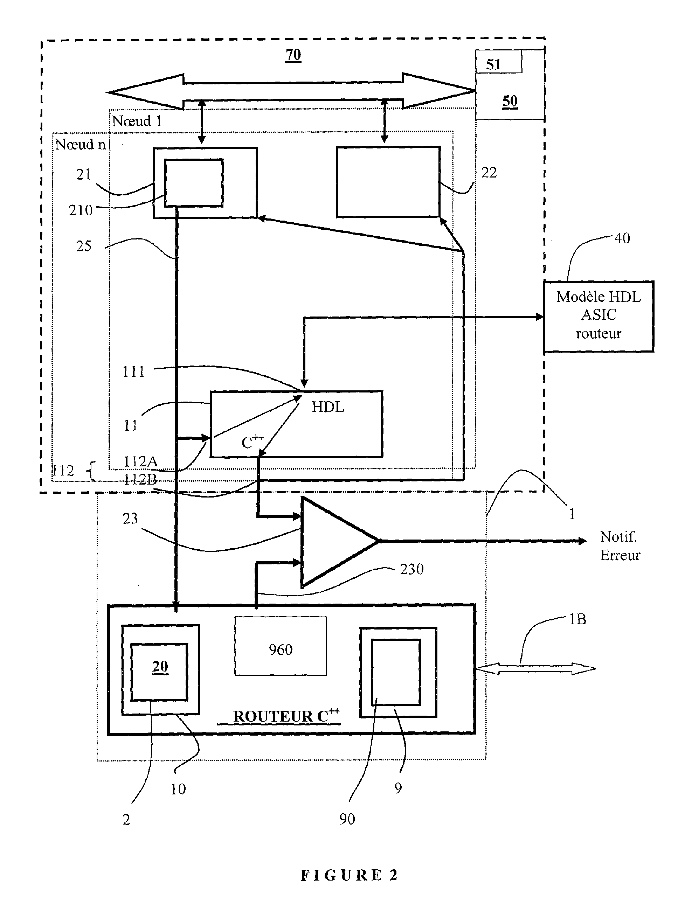

Sur la figure 1, la référence 1 désigne un émulateur de circuit intégré utilisable notamment pour les circuits intégrés en projet qui doivent être réalisés à la demande, et appelés ASIC. L'invention s'applique à tous types de circuits intégrés, par exemple un circuit simple de type microcalculateur ou un système complexe, tel que notamment un système multi-noeuds à mémoire cohérente. Les noeuds (Noeud 1,..., Noeud n) de mémoire sont interconnectés par le circuit intégré en projet. Un système multi-noeuds peut être, par exemple, un ensemble de cartes de circuits intégrés comportant des multiprocesseurs et/ou des entrées-sorties avec antémémoire formant une pluralité de noeuds de communication contenant des mémoires, et dont les noeuds peuvent émettre des requêtes simultanées vers des adresses de mémoire partagée. Le circuit intégré physique ASIC est absent de la figure 1 et un modèle logiciel de ce circuit en projet en langage type HDL de bas niveau porte la référence 40 sur la figure 2. L'émulateur 1 communique avec un ou plusieurs noeuds (Noeud 1,..., Noeud n). Chaque noeud peut communiquer avec une station client 50 ou l'ensemble des noeuds communique avec une seule et même station client 50. L'émulateur 1 est constitué autour d'un système de traitement de données 10, tel qu'un calculateur, qui reçoit, en mémoire 2, des données 20 de spécification fonctionnelle en langage de haut niveau, par exemple C⁺⁺, du modèle 40 de l'ASIC du projet à réaliser en langage de type HDL. Les données 20 définissent les réponses que doit présenter, sur ses sorties, l'ASIC, en projet à des états successifs présentés à ses entrées. Un bus d'accès local ou un moyen de communication 1B d'accès direct à l'émulateur 1, est ici prévu pour le gérer.

D'une façon générale, comme évoqué plus haut, les données de spécification fonctionnelle 20 déterminent que l'ASIC en projet à définir par son modèle de type HDL, présente, à un instant donné, un état de sortie déterminé, fonction de l'état d'entrée instantané qui lui est imposé, et fonction des états de ses mémoires "internes" éventuelles (EMI), usuellement existantes dans les ASICs. Par mémoire interne, on désigne les mémoires dont le contenu, lisible ou non de l'extérieur de l'ASIC 40, agit sur l'état d'autres circuits logiques ou séquentiels de l'ASIC 40. Les états des mémoires dépendent, de façon générale, des états antérieurs d'entrée de l'ASIC, c'est-à-dire de l'historique des séquences de stimuli d'entrée et sont mémorisés dans une mémoire 962 et dans le coeur 961 de l'émulateur.

L'émulateur 1 comporte également, en mémoire 9, un logiciel 90 d'exploitation des données 20 de spécification fonctionnelle. Le logiciel 90 comporte des programmes d'élaboration et de validation progressive de séquences de test de validation fonctionnelle de l'ASIC en projet. A chaque pas d'une séquence de test de validation fonctionnelle, le vecteur ou état de sortie, déterminé en fonction d'un vecteur d'entrée actuel et de l'historique, est mémorisé et mis à jour en mémoire 91. Cette mémorisation peut porter sur l'état des mémoires internes (EMI) de l'ASIC en projet, ce qui en pratique est nécessaire à chaque pas pour calculer les vecteurs de sortie instantanés successifs, et surtout elle peut porter sur l'évolution des états des mémoires internes de l'ASIC en fonction des vecteurs d'entrée successifs, représentant les effets de l'historique.

Il y a donc une double "modulation" par rapport à une simple bijection entrée/sortie.

En effet, d'une part, des vecteurs d'entrée différents, appliqués à des instants distincts dans une séquence de stimuli, peuvent avoir des effets qui "convergent", c'est-à-dire correspondent à un même vecteur de sortie, par l'effet des états des mémoires internes.

D'autre part, des vecteurs d'entrée identiques, appliqués à des instants distincts dans une séquence de stimuli, peuvent avoir des effets qui "divergent" en produisant des vecteurs de sortie différents, par l'effet des états des mémoires internes.

La spécification fonctionnelle définie par les données 20 peut spécifier, une table de vérité, ou de comportement, correspondant aux fonctions des diverses parties ou divers éléments de circuit fonctionnels du modèle de type HDL 40 de l'ASIC, mais aussi des plages de retard de propagation à respecter entre chaque entrée et chaque sortie. La plate-forme de vérification vérifie ainsi que les réponses de l'ASIC sont situées dans des plages de temps de réponse spécifiées dans la spécification fonctionnelle 20.

Le logiciel 90 d'élaboration des séquences de test de validation fonctionnelle, interprète ainsi les données de spécification 20 pour fournir, en tenant compte des états des mémoires internes (EMI) de l'émulateur que sont le coeur 961 et les mémoires 962 de statut dans la mémoire cache (antémémoire), le vecteur de sortie associé au vecteur d'entrée. Le vecteur d'entrée est fourni par un opérateur utilisateur mettant au point le programme de test (70).

La référence 30 désigne un bus informatique ou un moyen de communication, relié soit directement à un terminal d'un utilisateur soit à un réseau de transmission de données, permettant à un utilisateur de dialoguer en mode client-serveur avec l'émulateur 1 à travers un circuit 21 générateur de stimuli, traduisant les commandes transmises, par exemple par une interface de communication ("socket"), en stimuli et un circuit 22 gestionnaire d'interface, gérant l'interfaçage entre la station 50 d'au moins un client, et l'émulateur (1). Cet émulateur a ici une fonction d'interface de dialogue utilisateur-émulateur (50,1), utilisée dans une première étape illustrée par la figure 1. Comme cela est expliqué plus loin en regard de la figure 2, le circuit 21 sert à transmettre les stimuli générés par le client utilisateur dans la phase de validation fonctionnelle pour les appliquer en entrée du modèle 40 en langage de type HDL de l'ASIC et à l'émulateur 1, et le circuit 22 est un moniteur gérant les interfaces en entrée et en sortie entre une station client (50) et, d'une part, l'émulateur 1 et, d'autre part, les circuits 11 convertisseurs de langage évolué vers le langage de type HDL du modèle logiciel 40 de l'ASIC. Ces deux circuits (21, 22) constituent, avec l'adaptateur 11, l'émulateur d'environnement. Une mémoire 210 du circuit générateur de test 21 est prévue pour stocker des séquences de stimuli d'entrée, la mise au point et la mémorisation des séquences d'entrée dans leur forme définitive étant, dans cet exemple, effectuée par le programme.

Le schéma de la figure 1 illustre ainsi un mode de fonctionnement dit « émission », dans lequel l'émulateur 1, recevant, par le bus 30, des commandes de l'utilisateur spécifiant des séquences de stimuli d'entrée, émet en retour des stimuli de réponse représentant la réponse prévue pour le modèle logiciel en langage de type HDL 40 de l'ASIC, permettant ainsi de mettre au point l'émulateur d'environnement 51.

Le programme global de séquences de test 51, stocké côté client passera transitoirement dans la mémoire 210 d'un circuit 21 générateur de stimuli.

Dans cet exemple, comme l'illustre la figure 1, l'émulateur 1 est relié par le noeud 122 aux circuits 21, 22 à travers deux circuits 11 et 12 d'adaptation entre les deux langages de programmation, ces circuits d'adaptation étant reliés en série et ayant des fonctions d'adaptation mutuellement inverses. Le circuit d'adaptation 11, relié directement aux circuits 21 et 22, transforme des (commandes de) stimuli provenant de ceux-ci, écrits en langage de haut niveau, ici le langage C⁺⁺, en un langage de bas niveau, ici le langage de type HDL, directement interprétable par le modèle logiciel 40 en langage de type HDL de l'ASIC prévu, c'est-à-dire ici des commandes prévues pour être appliquées, comprises et exécutées par celui-ci. Les stimuli fournis par le circuit 21 en langage C⁺⁺ sont transformés en langage de type HDL par un port d'entrée/sortie 111 du circuit d'adaptation C⁺⁺/HDL 11. Il peut s'agir de commandes binaires très élémentaires, par exemple de portes logiques, ou de commandes plus élaborées, par exemple pour commander un processeur du modèle de type HDL 40 de l'ASIC. Ces dernières commandes peuvent, en particulier nécessiter une macro-commande, c'est-à-dire une séquence de stimuli de commandes élémentaires.

Le circuit 12 d'adaptation inverse HDL/C⁺⁺, relié au port 111, sert de frontal pour l'émulateur 1, afin que celui-ci, qui utilise le langage C⁺⁺, exploite, après adaptation du langage de type HDL vers le langage C⁺⁺, les stimuli initialement traduits en langage de type HDL par le circuit 11. Ce circuit 11 permet d'exprimer les stimuli dans leur forme réelle d'exploitation, prévus pour être effectivement appliqués au modèle logiciel 40 en langage de type HDL de l'ASIC de la figure 2, à partir du port 111. Cela permet donc de tester également le bon fonctionnement du circuit 11 d'adaptation C⁺⁺/HDL pour chacun des stimuli d'entrée.

Le circuit 11 d'adaptation C⁺⁺/HDL fournit ainsi, par le port d'entrée/sortie 111, des commandes ou programmes de niveau physique et logique directement compatibles avec le modèle logiciel 40 en langage de type HDL de l'ASIC prévu. Ces commandes sont la traduction de commandes logicielles ou programmes en langage de plus haut niveau, plus abstraites, symboliques, constituant un descripteur spécifiant les commandes physiques et logiques à appliquer réellement. Ainsi, dans cet exemple, l'élaboration des séquences de stimuli symboliques du programme de test 51, en langage de niveau supérieur au niveau physique et logique du modèle 40 de l'ASIC, permet de s'affranchir des particularités physiques et/ou de langage de programmation interne au modèle logiciel de type HDL 40 de l'ASIC et facilite donc l'écriture de ces séquences. Comme indiqué, c'est le circuit 11 d'adaptation C⁺⁺/HDL qui, dans une étape suivante de celle d'écriture des séquences, effectue la transposition voulue pour l'exécution pratique des séquences du programme de test 51.

Dans le sens opposé, de l'émulateur 1 vers le bus 30, les circuits d'adaptation de langage 12 et 11 ont les fonctions inverses de celles respectivement décrites, le circuit 12 transformant les données reçues de l'émulateur 1 et formulées en langage de haut niveau, C⁺⁺, en des données en langage de bas niveau, de type HDL. Le circuit 11 retransforme les mêmes données qui ont été formulées en langage de bas niveau, c'est-à-dire de type HDL, par le circuit 12 en des données en langage de haut niveau, c'est-à-dire C⁺⁺.

Comme indiqué ci-dessus, le modèle logiciel de type HDL 40 de l'ASIC, absent de la figure 1, y est représenté fonctionnellement par l'ensemble référencé 140 qui est constitué par l'émulateur 1 avec ici, en frontal, le circuit d'adaptation 12, dont un port d'entrée/sortie 121 reçoit les commandes de bas niveau du port 111 et les transmet à l'émulateur 1, par un port d'entrée/sortie 122, après les avoir retransformées en un langage de haut niveau. En pratique, ici, c'est le même que celui utilisé par le circuit générateur de stimuli 21, c'est-à-dire le langage C⁺⁺, mais l'invention s'applique également au cas où le langage utilisé par le circuit 21 serait, certes évolué, mais différent de C⁺⁺. Ainsi, l'utilisateur peut dialoguer avec l'émulateur 1 au moyen d'un langage de haut niveau, C⁺⁺, les circuits d'adaptation de langage 11 et 12 ayant des effets qui s'annulent et qui sont ainsi totalement masqués fonctionnellement à l'utilisateur, dans la mesure où le circuit 11 ne présente pas de défaut de fonctionnement, comme évoqué précédemment.

Comme indiqué plus haut, l'ensemble constitué par l'émulateur 1 et son adaptateur de langage 12 constitue un émulateur parfaitement conforme au modèle logiciel 40 en langage de type HDL de l'ASIC, mais la mise au point de ces séquences de stimuli s'effectue par utilisation du langage de haut niveau, s'affranchissant des spécificités matérielles de l'ASIC et des spécificités des langages de bas niveau de description des circuits intégrés, tel que le langage de type HDL. Cette mise au point permet aussi de vérifier, en particulier, que le circuit d'adaptation 11, qui sera utilisé dans la configuration de la figure 2, fournit l'adaptation voulue pour chaque type de stimuli du programme de test 70 mis au point. En d'autres termes, la mise au point du programme de test 70 s'effectue dans le langage de haut niveau C⁺⁺, mais elle comporte une vérification du bon fonctionnement de l' « échelle » (circuit d'adaptation 12) qui permettra de faire « descendre » le programme de test 70 du langage symbolique C⁺⁺ au langage de bas niveau de type HDL directement exploitable par le modèle de type HDL 40 de l'ASIC.

Les séquences de test de validation fonctionnelle sont mises au point par un utilisateur relié au bus 30 en envoyant les stimuli d'entrée et recevant en retour des réactions du logiciel 90 d'exploitation en mémoire 9, qui signale des défauts éventuels dans l'élaboration du programme global de séquences de test, et permet leur correction. Une fois les séquences de test de validation fonctionnelle mises au point, l'ensemble de ces dernières constituant le programme de test 51, est recopié dans la mémoire d'exploitation 210 du circuit générateur de stimuli 21.

La figure 2 illustre une phase suivante de fonctionnement, dite de « vérification », dans laquelle est effectué un test de validation fonctionnelle du modèle logiciel 40 de l'ASIC en langage de type HDL. Dans cette phase, sous la commande des stimuli du programme de test 51 émis par la mémoire 210, les divers états -d'entrées soumis au modèle logiciel de l'ASIC, sont également soumis, en entrée, à l'émulateur 1 qui élabore, par le programme 90 en dynamique, les sorties prévisibles qui apparaissent successivement en sortie 230 de l'émulateur 1, en réutilisant précisément la même spécification fonctionnelle 20 que celle utilisée pour le mode « émission ». Les sorties de l'émulateur 1 évoluent en synchronisme avec l'état, réel, des sorties du modèle logiciel 40 de l'ASIC en langage de type HDL, ce qui permet de détecter toute discordance du fonctionnement cible prévu, défini par l'émulateur 1.

Sur la figure 2, l'émulateur 1 dialogue directement avec un circuit générateur de stimuli 21 et un circuit moniteur d'interface 22 pour chaque noeud du modèle logiciel, puisque l'adaptation de langage C⁺⁺/HDL effectuée par le circuit d'adaptation 11 a été vérifiée selon le schéma de la figure 1. Le circuit d'adaptation inverse 12 est donc omis. Le modèle logiciel 40 de l'ASIC en langage de type HDL est alors relié au port 111 du circuit d'adaptation 11 (dessiné retourné), servant de frontal d'adaptation de langage. En d'autres termes, le modèle logiciel 40 de l'ASIC en type HDL de la figure 2 remplace l'ensemble 140 constitué, sur la figure 1, par l'émulateur 1 avec son circuit frontal d'adaptation 12. L'émulateur 1 de la figure 2 sert alors à contrôler, par comparaison, les réponses réelles du modèle logiciel 40 de l'ASIC en langage de type HDL à celles prévues par l'émulateur 1.

Le port 112 est ici représenté éclaté en un port d'entrée 112A, relié au circuit générateur de stimuli de test 21 par une liaison 25, et un port de sortie 112B relié à un comparateur 23. Le modèle de type HDL de l'ASIC 40 présente ainsi, pour son environnement, une interface 112A, 112B de dialogue dans le langage de haut niveau, ici C⁺⁺, utilisé par les autres circuits 1, 21, 22 et 23.

L'émulateur 1 est alors relié en entrée à la liaison 25, donc directement en parallèle sur le port d'entrée 112A pour recevoir, tout comme le modèle de type HDL 40 de l'ASIC à travers le circuit d'adaptation 11, les séquences de stimuli mémorisées en mémoire 210 correspondant au programme de test de validation 70 en langage de haut niveau, qui a été mis au point selon le schéma de la figure 1. L'émulateur 1 fournit en réponse, au comparateur 23, un état, ou stimuli, ou encore vecteur, de sortie, fonction des données de spécification 20, qui est considéré comme étant l'état de sortie cible, ou de référence, associé à l'état d'entrée. Il s'agit donc, parmi les états de sortie prévisibles, de celui qui est déterminé ou sélectionné d'après l'état d'entrée fourni au vérificateur 960. Nous expliciterons ultérieurement le rôle du vérificateur 960.

Le modèle le modèle logiciel en langage HDL de l'ASIC fournit aussi, de son côté, un état de sortie qui est transformé par le circuit d'adaptation 11 pour être présenté dans le langage de haut niveau C⁺⁺, cet état de sortie étant en principe identique à celui prévu par l'émulateur 1. Le circuit comparateur 23 a été dessiné pour illustrer la comparaison des sorties qu'il reçoit et il fait en réalité fonctionnellement partie de l'émulateur 1. Le comparateur 23 compare les états de sortie du modèle de type HDL 40 de l'ASIC, reçus par le port 112B, et les stimuli de sortie fournis par le vérificateur 60 de l'émulateur 1 pour détecter une éventuelle discordance et la signaler à l'utilisateur client. En pareil cas, cela indique un défaut de conformité du modèle logiciel 40 en langage de type HDL de l'ASIC avec la spécification 20, dû à un défaut de conception ou à une erreur de fonctionnalité au niveau de l'ensemble modèle ASIC-programme de test. La sortie du comparateur 23 remplit un fichier enregistrant des notifications d'erreurs en cas de comparaison non concluante. Le circuit moniteur d'interface 22 et le circuit générateur de stimuli 21 reçoivent les sorties du modèle de type HDL pour permettre de tenir compte des réponses antérieures dans la génération de stimuli et pour le générateur 21 générer des fichiers de trace.

Comme évoqué plus haut, le client peut, en variante ou en complément, écrire et fournir tout ou partie de la spécification fonctionnelle 20 sous la forme d'un programme dans un langage de bas niveau, tel que défini plus haut, remplaçant ou complétant un programme homologue de haut niveau. Dans le cas où la spécification fonctionnelle 20 est ainsi définie au total dans deux langages différents par leurs niveaux ou autre, le client utilisateur commande alors l'émulateur 1 pour que le logiciel 90 d'élaboration de test, prévu à cet effet, effectue une co-simulation, ou co-émulation, par synchronisation d'exécution des deux programmes de spécification.

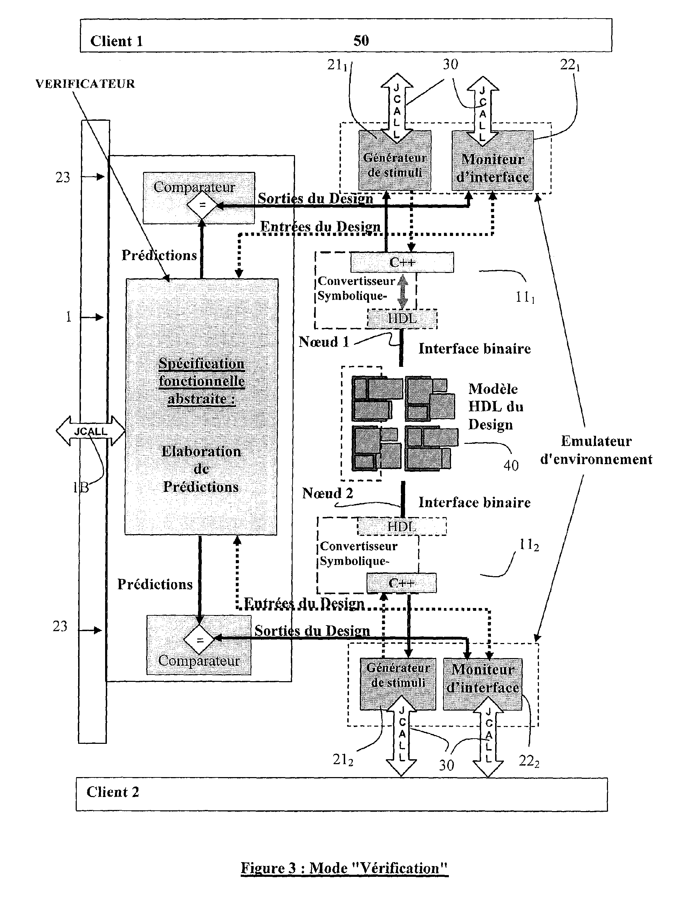

La figure 3 reprend les éléments représentés sur la figure 2, avec, toutefois, une duplication du circuit d'adaptation du langage 11₁ respectivement 11₂ pour un premier et un second noeud et des circuits 21₁, 21₂, 22₁, 22₂ et du bus 30 d'interface de liaison avec les clients utilisateurs, pour un fonctionnement multi-noeud (Noeud 1, Noeud 2) et multi-utilisateur (Client 1, Client 2).

La figure 3 représente un mode de réalisation de la plate-forme de vérification de l'invention dans laquelle on inclut le modèle d'élaboration de prédiction, ou émulateur 1, constituant le vérificateur permettant de vérifier la conformité du modèle de type HDL de l'ASIC développé par rapport à la spécification fonctionnelle et aux tests élaborés pour vérifier cette spécification fonctionnelle.

Dans la suite du document, ROUTEUR désigne : soit le modèle logiciel en langage de type HDL du circuit en projet, qui est un circuit routeur permettant le routage d'information dans un système multi-noeuds, soit l'émulateur de ce circuit en mode émission.

Une transaction du système s'exécute de la façon suivante.

Le contexte d'exécution de l'émulateur du ROUTEUR est un système multi-noeuds à mémoire cohérente, ces noeuds étant interconnectés par le ROUTEUR. Un système multi-noeuds peut être, par exemple un ensemble de cartes de circuits intégrés comportant des multiprocesseurs, et/ou des entrées-sorties formant une pluralité de noeuds de communication contenant des mémoires et dont les noeuds peuvent émettre des requêtes simultanées vers des adresses de mémoire partagée.

Les composantes d'une transaction sont les suivantes.

Un noeud peut émettre des requêtes dites primaires, de type lecture, écriture, invalidation. Ces requêtes recevront une ou plusieurs réponses dites primaires. Le ROUTEUR peut être amené, pour traiter une requête primaire émise par un premier noeud P, à générer une ou plusieurs requêtes dites secondaires vers des noeuds S distincts du premier noeud P. Chaque noeud S émettra une ou plusieurs réponses dites secondaires. L'ensemble de ces réponses secondaires servira au ROUTEUR à émettre la réponse primaire.

L'ensemble {requête et réponse(s) primaire(s), requête(s) et réponse(s) secondaire(s)} constituent une transaction.

Les noeuds disposent d'une antémémoire pour mémoriser les blocs de mémoire utilisés contenant, soit des adresses, soit des données.

Le ROUTEUR dispose d'une antémémoire (appelée DIRECTORY dans la suite du document) pour mémoriser les blocs utilisés par les noeuds d'après leur adresse. Pour une adresse utilisée par un ou plusieurs noeuds, un vecteur de présence est géré avec, par noeud, un témoin de présence. Cette mémoire cache permet de limiter la génération des requêtes secondaires aux noeuds utiles pour l'exécution de la transaction (exemple : invalidation propagée vers les noeuds qui ont le témoin de présence valide)

Le ROUTEUR peut être amené à traiter plusieurs transactions relatives au même bloc mémoire. Cet ensemble de transactions est appelé collision. Le ROUTEUR les prend en compte de manière sérielle. L'ordre dans lequel le ROUTEUR les prend en compte est appelé ordre de sérialisation.

Pour chaque requête primaire, le ROUTEUR est amené à déterminer l'état final du bloc mémoire.

[cas a] Si la détermination de cet état final par le ROUTEUR requiert une ou plusieurs {requête, réponses(s) secondaire(s)}, la transaction passe en section critique (jusqu'à la réception des réponses secondaires); visible de l'émulateur.

[cas b] Dans le cas contraire, l'émulateur n'a connaissance de la décision du ROUTEUR qu'au travers des réponses primaires.

La difficulté pour l'émulateur de suivre l'activité du ROUTEUR vient du fait que les transactions répondant au second cas [cas b] ont leur point de sérialisation non visible par l'émulateur.

Par contre, les transactions répondant au premier cas [cas a] ont leur point de sérialisation visible de l'émulateur, et offrent à l'émulateur une aide importante dans le suivi de l'activité du ROUTEUR.

L'émulateur en mode vérification va effectuer des prédictions. Pour suivre l'activité du ROUTEUR en cas de collision, l'émulateur doit prédire l'ensemble des ordres de sérialisation possibles et pertinents qu'amène cette collision.

La génération des prédictions consiste en la production, pour chaque cas de sérialisation envisagé, des profils des requêtes secondaires, réponses primaires et secondaires qui devraient apparaître aux interfaces du ROUTEUR.

L'observation d'une sortie du ROUTEUR (requête secondaire, réponse primaire) est confrontée aux profils des prédictions. En cas de non-correspondance, la prédiction est rejetée.

Si aucune prédiction ne répond à l'observation, l'émulateur signale une erreur.

La programmation objet a permis : d'une part, de structurer l'émulateur de BOUTEUR en un ensemble de classes spécialisées et, d'autre part, de simplifier le traitement par la localisation et spécialisation de ces traitements à chaque instance de chaque classe.

Les classes suivantes sont utilisées par l'invention :
- La classe "Txnld".
   Une instance (T) de cette classe assure le suivi de l'exécution d'une transaction.
   Cette instance T gère une collection d'hypothèses d'exécution (qui sont des instances de la classe TxnldHypothesis).
   Une hypothèse d'exécution est conservée tant que les observations des sorties du ROUTEUR sont conformes aux prédictions faites par cette hypothèse.
   L'exécution de cette instance T est considérée comme correcte tant qu'il existe au moins une hypothèse vivante.
   Cette instance T est en charge de vérifier la fin d'exécution de la transaction (c'est-à-dire qu'il existe des hypothèses vivantes ayant observé toutes les sorties du ROUTEUR prédites).
- La classe "TxnldHypothesis".
   Une instance (TH) de cette classe assure le suivi d'une hypothèse d'exécution d'une transaction.
   Cette instance (TH) gère une instance de la classe Syst_Xaction.
   Cette instance (TH) est en charge de contrôler que les observations des sorties du ROUTEUR sont conformes aux prédictions de cette hypothèse.
   L'instance (TH) est en charge de gérer les réponses aux requêtes secondaires.
- La classe "Syst_Xaction".
   Une instance (SX) de cette classe mémorise les informations relatives à la requête primaire, et à la (aux) requête(s) secondaire(s) prédite(s) par l'hypothèse attachée.
   Cette instance (SX) mémorise également des marques d'exécution de la transaction.
- La classe "CollisionScenario".
   Une instance (CS) de cette classe gère une sérialisation possible de transactions en collision. Cette instance (CS) gère également le cas de non-collision (c'est-à-dire le cas d'une transaction en cours sur un autre bloc mémoire).
   Pour chaque transaction concernée, une hypothèse d'exécution de cette transaction est attachée à l'instance (CS).
   L'instance (CS) gère une liste ordonnancée d'instances de la classe "CollisionElement".
   Cet ordonnancement reflète la sérialisation des transactions en collision.
- La classe "CollisionElement".
   Une instance (CE) de cette classe gère l'état d'exécution d'une hypothèse d'exécution d'une transaction dans un contexte de collision.
   Les principaux états d'exécution sont :
   - ASLEEP : aucune observation de sorties du ROUTEUR n'a été faite pour cette hypothèse.
   - PREDICTED : toutes les prédictions pour assurer le suivi de l'hypothèse sont élaborées.
   - WTSNOOP, WTCMP: la transaction est en section critique, en attente d'une (de) réponse(s) secondaire(s).
   - WTTRANS : aucune observation de sorties du ROUTEUR ne peut avoir lieu pour cette hypothèse.
   - COMPLETED : la transaction est terminée.

   Pour les états ASLEEP et WTTRANS, aucune prédiction n'a été réalisée.
   L'état WTTRANS est atteint pour une hypothèse dont la sérialisation devra attendre la fin de section critique d'une autre transaction.
   L'instance (CE) gère également une instance de la classe "DirectoryEntry".
- La classe "DirectoryEntry".
   Une instance (DE) de cette classe gère l'état (ESI) d'un bloc mémoire, ainsi que le vecteur de présence de ce bloc dans les noeuds périphériques du ROUTEUR.
   Ces informations reflètent celles dont le ROUTEUR dispose pour gérer le bloc.
   Chaque indice du vecteur de présence (ou témoin de présence) indique :
   - soit la présence certaine du bloc dans le noeud attaché ;
   - soit la présence potentielle du bloc dans le noeud attaché.
      Dans certaines occasions (par exemple l'exécution de certains types de transaction dans un contexte de collision), le ROUTEUR peut effacer ou maintenir un témoin de présence, sans indication de cet événement au travers de sorties spécialisées observables par l'émulateur.
- La classe "Transition".
   Cette classe gère l'activation d'une transition relative à un événement (EV) (requête primaire, ou réponse secondaire dans un contexte de section critique) et à une instance DE.
   La transition à activer est recherchée dans une table (instance de la classe TransitionTable).
   Cette activation conduit à la mise à jour de l'instance (DE) et à l'activation d'une instance de la classe "TransitionAction".
   La classe "TransitionTable".
   Cette classe décrit de façon générique toutes les transitions autorisées par le protocole.
   Pour chaque état d'une instance (DE), pour chaque type d'événement EV, sont spécifiés comment mettre à jour l'instance DE et l'instance de la classe "TransitionAction" à activer.
- La classe "TransitionAction".
   Cette classe englobe les différents types d'action génériques à accomplir suite à la réception d'un événement EV.
   Ces actions prennent en paramètres la requête primaire, le contenu de l'instance DE associée.
   Parmi ces actions, on trouve entre autres :
   - la propagation d'invalidation vers les noeuds ayant le témoin de présence dans l'instance DE;
   - la propagation vers le noeud détenteur du bloc mémoire cible, d'une lecture ou mise à jour de ce bloc;
   - la propagation d'une réponse vers le noeud initiateur de la requête primaire.

   Le terme « propagation » reflète la génération des prédictions qui seront confrontées aux observations des sorties du ROUTEUR.
- La classe "Directory".
   Une instance (D) de cette classe gère les instances DE associées aux blocs mémoires présents dans les filtres du ROUTEUR.
   Une instance DE indique un état stable du bloc si aucune transaction n'est en cours d'exécution sur ce bloc.
   Dans le cas contraire, l'entrée DE mémorise les instances T en cours d'activité sur ce bloc.
   Le prochain état de cette instance DE est alors en cours d'évaluation dans les différentes instances CE/CS associées à ces instances T.
- La classe "VerifierCore".
   Une instance (VC) de cette classe gère l'ensemble de l'activité.
   VC reçoit les stimuli (requêtes/réponses primaires/secondaires), crée les instances T à la réception des requêtes primaires, soumet les stimulis à ces instances et les détruit en fin de transaction.

Les algorithmes du ROUTEUR réalisent les fonctions suivantes:
- Fonction de génération des prédictions :
   Sur observation d'une requête secondaire ou réponse primaire (émise par le routeur) relative à une transaction t, tous les scénario pertinents (i.e. différents ordres de sérialisation) mettant en jeu cette transaction et celles en collision sont évalués.
- Fonction d'élimination de prédictions :
   Une prédiction est écartée (i.e. l'instance CS de la classe CollisionScenario est détruit) si, dans cette instance CS, l'état de l'instance cible de la classe "CollisionElement" n'est pas compatible avec l'observation, ou si, dans cette instance CS, la prédiction gérée par l'instance cible de la classe "TxnldHypothesis" n'est pas conforme à l'observation (exemple : non-conformité entre profil de l'observation et de la prédiction).
- Fonction de ré-ajustement de mauvaise prédiction :
   Dans certaines occasions (exécution de certains types de transaction dans un contexte de collision), le ROUTEUR peut effacer ou maintenir un témoin de présence dans son antémémoire (Directory), sans indication de cet événement au travers de sorties spécialisées observables par l'émulateur. Par défaut, l'émulateur de ROUTEUR génère des prédictions avec témoin de présence effacé.
   Si une observation montre que le choix inverse serait plus judicieux, les instances de la classe "CollisionScenarios" concernées sont ré-évaluées en maintenant le bit de présence en question.
- Fonction de réduction du nombre d'hypothèses valides :
   Pour assurer le suivi d'une collision, l'émulateur de ROUTEUR est amené à gérer un nombre d'instances de la classe "CollisionScenario" qui peut devenir élevé.
   Certains cas de collision peuvent produire les mêmes observations pour les sérialisations obtenues en permutant l'ordre de prise en compte des transactions concernées.
   Pour limiter le nombre d'instances de la classe "CollisionScenario", l'émulateur de ROUTEUR détecte dans chaque instance "CollisionScenario", les sous-ensembles d'instances de "CollisionElement" dans l'état COMPLETED ou PREDICTED, pour lesquels l'état de l'instance DE attachée n'a pas évolué.
   Ces sous-ensembles sont ré-ordonnancés. Les doublons sont éliminés
- Fonction de terminaison des collisions :
   L'émulateur de ROUTEUR détecte, sur l'ensemble des instances de la classe "CollisionScenarios" relatifs à une collision, les situations où les n premières instances de la classe "CollisionElements" sont relatifs aux mêmes transactions et aboutissent à des états de l'antémémoire (Directory) compatibles.

Ces instances de la classe "CollisionElements" sont alors détruites, l'instance de la classe "DirectoryEntry" correspondante dans la Directory est mise à jour.

L'organisation de l'émulateur ainsi défini a permis de simplifier le traitement par la localisation et la spécialisation de ces traitements à chaque instance de chaque classe, d'isoler une transaction, une collision, et de spécialiser les classes pour permettre une généricité des traitements.

L'isolation d'une transaction, d'une collision est obtenue par le fait qu'une transaction est modélisée au travers d'une entrée dans la table des transactions. Cette entrée consiste en un pointeur vers une instance T de la classe Txnld. Cette instance pointe vers des instances TH de la classe "TxnldHypothesis". Chaque instance TH pointe vers une instance SX de la classe "Syst_Xaction", vers une instance CS de la classe "CollisionScenario", et dans cette instance de la classe "CollisionScenario", vers une instance CE de la classe "CollisionElement".

Cette instance CE pointe vers une instance DE de la classe "DirectoryEntry".

Les avantages de cette organisation sont, d'une part, l'étanchéité entre les traitements des transactions et, d'autre part, le suivi aisé d'une transaction, d'une collision (objets liés par pointage).

L'étanchéité entre les traitements des transactions assure une robustesse des traitements par rapport à la charge, une facilité de mise au point (un problème lié au traitement d'une collision est indépendant de la charge et peut donc être analysé en rejouant uniquement cette collision).

Le suivi aisé des traitements allège les phases de mise au point et le suivi du programme.

La spécialisation des classes et la généricité des traitements sont dues au fait que les classes "Transition", "TransitionTable" et "TransitionAction" sont spécialisées dans le traitement des transitions et gèrent de manière indépendante une part très importante du protocole. Elles peuvent être facilement adaptées à d'autres protocoles de type MESI.

Les classes "CollisionScenario", "CollisionElement" sont spécialisées dans le traitement des ordres de sérialisations. Les seules informations manipulées sont les états possibles des transactions (état final du bloc prédictible, section critique nécessaire) et les états de l'antémémoire (Directory) produits par les transitions. Des algorithmes de limitation du nombre de "CollisionScenario", indépendants du protocole, peuvent être appliqués, basés sur les états finaux fournis par les transitions.

Les classes "Txnld", "TxnldHypothesis", "Syst_Xaction" sont spécialisées dans le suivi de l'exécution d'une transaction (mémorisation des requêtes secondaires en cours, divers témoins d'exécution, prise en compte des réponses secondaires) et dans la comparaison des profils des prédictions et observations.

Les classes"Directory" et "DirectoryEntry" sont spécialisées dans la gestion de la mémoire cache (antémémoire).

Tous les protocoles de mémoire cache peuvent être facilement intégrés.

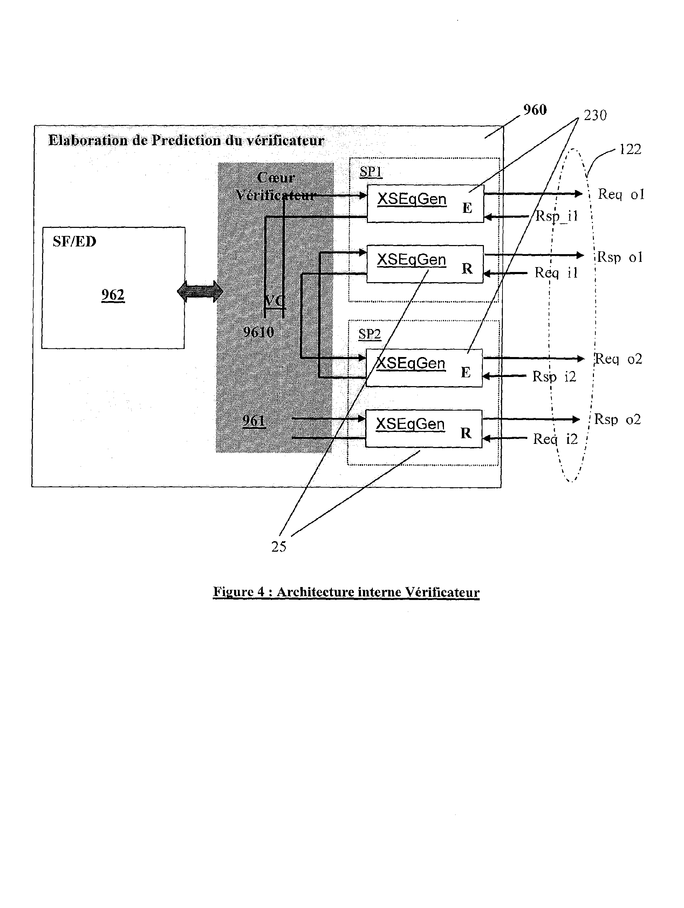

La figure 4 représente l'architecture interne du vérificateur.

Chacun des clients émet, à travers des commandes d'appels JCALL, des requêtes de tests du modèle de type HDL 40 du circuit ASIC. Ces commandes sont transmises au générateur de stimuli 21 et moniteur d'interface 22 qui les envoie, d'une part, vers le circuit vérificateur de l'émulateur 1 pour élaborer des prédictions de réponses du modèle de l'ASIC, d'autre part, vers le circuit 11 convertisseur d'un langage évolué en C⁺⁺ vers un langage de bas niveau de type HDL de description du hardware du circuit ASIC et, à travers ces convertisseurs, vers le modèle de type HDL du circuit ASIC.

Les requêtes sont reçues par les interfaces de traitement XSEqGen (figure 4) du vérificateur 960 et également utilisées dans les circuits 21, 22 générateurs de stimuli pour transmettre et vérifier les paquets de requête. Deux instances sont utilisées pour chaque interface du vérificateur 60, une première recevant les requêtes à destination de l'émulateur 1 agit comme répondeur, l'autre transmettant les requêtes de l'émulateur agit comme un émetteur mais toutes deux sont identiques.

Le noyau vérificateur 961 est le composant central élaborant les prédictions en fonction des adresses, dans le répertoire 962 (SF/ED) de la mémoire, du vecteur de présence des stimuli de réponse et des paquets reçus représentant les stimuli d'entrée. L'organisation du noyau 961 de vérification est réalisée autour de classes instanciées sous forme d'objets. Le noyau vérificateur 961 mémorise des registres de configuration pour le routage des requêtes non cohérentes, la détermination de la localisation de la mémoire pour les requêtes cohérentes, les gestions des domaines. Le noyau de vérificateur inclut un tableau 9610 pour les transactions en cours d'utilisation à l'intérieur du vérificateur. Chaque entrée du tableau pointe vers une instance de la classe TXNID qui représente la transmission de la transaction à l'intérieur du vérificateur.

Chaque fois qu'une requête d'entrée cohérente est reçue par le vérificateur 961, une structure temporaire est créée pour prédire quelle transaction du répertoire sera utilisée comme adresse bloc et quelles seront les sorties prédites pour le modèle du circuit ASIC en test vers le circuit de transmission XSEqGen. Cette structure temporaire est une instance de la classe « élément de collision ». Le traitement d'une transaction utilise toujours cette structure même si aucune collision avec une autre transaction n'est détectée.

Pour exécuter la prédiction, l'entrée de répertoire (instance de la classe entrée de répertoire) utilisée par ce bloc est copiée et utilisée par l'instance élément de collision de la classe "CollisionElement". La prédiction de l'exécution est traitée par l'usage des instances des classes "Transition" et des classes « action de transition » ("TransitionAction"). Les instances des classes « Transition » et « action de transition » font partie de la spécification fonctionnelle contenue dans la mémoire (2). Les instances de cette classe sont créées au moment de la simulation et fournissent des méthodes fonction de la génération de transition d'état et de la génération de requêtes envoyées ou de réponses fournies par le vérificateur. Ces méthodes sont activées par les instances d'éléments de collision de la classe "CollisionElement".

Le fonctionnement du noyau repose sur l'utilisation d'un certain nombre de classes qui sont utilisées, d'une part, pour décrire des ressources et, d'autre part, pour décrire des méthodes utilisées par les instanciations de cette classe dans un objet. Cette structure sous forme de classes permet de réaliser une plate-forme de vérification facilement modifiable en instanciant de nouveaux objets, permettant ainsi de décrire de nouvelles procédures de tests ou de nouvelles réponses à des stimuli reçus par de nouvelles fonctionnalités ajoutées sur le circuit. On peut ainsi aisément adapter la plate-forme à de nouveaux circuits développés.

Il doit être clair pour le lecteur que lorsqu'on utilise le terme HDL ou modèle de type HDL, on fait référence à un langage de description d'un circuit intégré qui est considéré comme étant de plus bas niveau par rapport au langage C⁺⁺ dit de haut niveau, mais ceci ne doit pas être interprété limitativement car l'invention s'applique également à tout autre langage de description d'un circuit intégré, tel que par exemple VHDL ou verilog ou encore tout autre.

On conçoit que la présente invention peut être mise en oeuvre selon d'autres formes spécifiques, sans sortir de son domaine d'application tel que revendiqué. Par conséquent, la présente description détaillée doit être considérée comme étant une simple illustration d'un cas particulier dans le cadre de l'invention et peut donc être modifiée sans sortir du domaine défini par les revendications jointes.

## Revendications

1. Procédé de vérification fonctionnelle d'un modèle logiciel (40) d'un circuit intégré à la demande (ASIC), en langage de bas niveau (tel que par exemple de type HDL) traitant de façon séparée l'établissement du modèle et la mise au point des tests de vérification fonctionnelle à appliquer au modèle du circuit pour constituer une plate-forme de vérification comportant les deux étapes suivantes :
- constitution d'un émulateur autonome (1) de circuit obtenu en remplaçant le modèle en langage de bas niveau (de type HDL) de description physique du circuit en projet à valider, par une description abstraite de haut niveau (par exemple C⁺⁺) générant des structures de données de réponse conformes à la spécification fonctionnelle (20) du projet en fonction des stimuli reçus, ce mode étant dit « mode émission »,
- intégration du modèle logiciel (40) en langage de bas niveau (de type HDL) du circuit résultant du projet dans une plate-forme de vérification, et constitution du branchement de l'émulateur autonome (1) de circuit, précédemment validée, en parallèle sur les interfaces du modèle logiciel (40) du circuit, et du branchement d'un émulateur d'environnement (11, 21, 22), et
- utilisation de cette plate-forme comme référence pour la validation des données de réponses émises par le modèle logiciel (40) du circuit, ce mode étant dit « mode vérification ».

2. Procédé selon la revendication 1, dans lequel :
• un utilisateur élabore, au moyen d'un système de traitement de données, la configuration de simulation autonome (1) correspondant au modèle logiciel (40) de l'ASIC au moyen de la spécification fonctionnelle (20),
• l'utilisateur écrit, à partir de la spécification fonctionnelle (20), et mémorise, dans une plate-forme de test (21, 22, 23) de modèles de circuits intégrés, un programme (51) de test du modèle (40) de l'ASIC, comportant des séquences de stimuli d'entrée à fournir au modèle logiciel (40) de l'ASIC, auxquelles la configuration de simulation autonome (1) fait correspondre, en fonction de la spécification fonctionnelle (20), des séquences de stimuli de sortie,
• l'utilisateur relie ensemble et active la configuration de simulation autonome (1) et la plate-forme de test (21, 22, 23), et
• il observe les stimuli de sortie du modèle de type HDL (40) de l'ASIC pour valider fonctionnellement l'ensemble constitué par le modèle logiciel du circuit ASIC et le programme de test de validation (210), et ainsi valider le modèle logiciel (40) par rapport à la spécification fonctionnelle (20).

3. Procédé selon l'une des revendications 1 et 2, dans lequel, la configuration de simulation autonome (1) communiquant avec l'utilisateur pour commander l'activation de modèles, préalablement établis et mémorisés, de séquences de stimuli d'entrée définis dans un langage de programmation de haut niveau, et commande l'activation de programmes associés (90) de validation progressive de séquences de test déterminées à partir des modèles.

4. Procédé selon l'une des revendications 1 à 3, dans lequel l'utilisateur écrit et fournit la spécification fonctionnelle (20) dans un langage de programmation de bas niveau, spécifiant des modèles fonctionnels de circuits.

5. Procédé selon l'une des revendications 1 à 4, dans lequel l'utilisateur fournit la spécification fonctionnelle (20) sous la forme d'un programme en langage de bas niveau, de modèles (de type HDL) fonctionnels de circuits, et d'un programme en langage de haut niveau, de modèles fonctionnels ((C⁺⁺) symboliques de circuits), et il commande la configuration de simulation autonome (1) pour effectuer une co-simulation par synchronisation d'exécution des deux programmes de spécification.

6. Procédé selon l'une des revendications 1 à 4, dans lequel la plate-forme de test vérifie que les réponses du modèle logiciel de l'ASIC sont situées dans des plages de temps de réponse spécifiées dans la spécification fonctionnelle (20).

7. Plate-forme de vérification de modèle logiciel de circuit intégré à la demande (ASIC), **caractérisé par le fait qu'**elle comporte des moyens de traitement de données permettant à un client de sélectionner des modèles de test engendrant des stimuli d'entrée de l'ASIC, ces moyens de traitement étant agencés pour lire des éléments (20) de spécification fonctionnelle de l'ASIC, et comportant des programmes (90) agencés pour élaborer un programme de test (51) de validation fonctionnelle constitué de stimuli de sortie à partir des stimuli d'entrée et des éléments de spécification fonctionnelle (20).

8. Plate-forme de vérification selon la revendication 7, comportant une bibliothèque de modèles fonctionnels de blocs de circuits pour ASIC et des moyens de sélection des modèles par un fichier de définition de la configuration pour constituer un modèle correspondant à la spécification fonctionnelle de l'ASIC intégré à la définition de son environnement.

9. Plate-forme de vérification selon l'une des revendications 7 et 8, dans laquelle il est prévu, dans une liaison le reliant au client, deux circuits en série d'adaptation de langage de programmation (11, 12) agencés pour transformer des commandes en langage de haut niveau (C⁺⁺), utilisé par le client, en commandes en langage de bas niveau (de type HDL), exploitables par le modèle de l'ASIC, et pour, respectivement, retransformer les commandes en langage de bas niveau en commandes en langage de haut niveau.

10. Plate-forme de vérification selon une des revendications 7 à 9, **caractérisé par le fait qu'**elle comporte des moyens (90, 10) d'exécuter ses traitements en même temps que la simulation qu'il peut interrompre dès la détection d'une erreur au moment même de l'apparition de l'erreur.

11. Plate-forme de vérification selon une des revendications 7 à 10 **caractérisé par le fait que** les éléments (20) de spécification fonctionnelle sont constitués d'une table de vérité, ou de comportement, correspondant aux fonctions des diverses parties ou divers éléments de circuit fonctionnels du modèle logiciel (40) de l'ASIC, et des plages de retard de propagation à respecter entre chaque entrée et chaque sortie.

12. Plate-forme de vérification selon une des revendications 7 à 11, **caractérisé par le fait qu'**elle dispose d'une antémémoire (962) pour mémoriser les blocs utilisés par les noeuds d'après leur adresse et des moyens de gérer, pour une adresse utilisée par un ou plusieurs noeuds, un vecteur de présence avec un témoin de présence par noeud.

13. Plate-forme de vérification selon une des revendications 7 à 12, **caractérisé par le fait que** les programmes (90) sont orientés objet et l'émulateur est structuré en un ensemble de classes permettant de gérer une collection d'hypothèses d'exécution d'une transaction sur un bloc mémoire du modèle logiciel, et de gérer également les transactions en collisions, c'est-à-dire utilisant concurremment un même bloc mémoire.

14. Plate-forme de vérification selon une des revendications 7 à 13 **caractérisé par le fait que** les algorithmes des programmes (90) de l'émulateur réalisent les fonctions suivantes : génération des prédictions, élimination des prédictions, ré-ajustement de mauvaise prédiction, réduction du nombre d'hypothèses valides et terminaison de collisions.

15. Plate-forme de vérification selon une des revendications 7 à 14 **caractérisé par le fait qu'**elle est utilisée en émulateur de circuit routeur, de circuit à antémémoire ou de circuit routeur à antémémoire.

16. Plate-forme de vérification, selon une des revendications 7 à 15, pour tester un modèle logiciel de circuit intégré à la demande (ASIC), **caractérisée en ce qu'**elle comporte un émulateur d'ASIC (1) pour commander un comparateur (23) prévu pour recevoir des valeurs générées par le modèle logiciel de circuit ASIC testé, sur réception de stimuli envoyés par au moins un circuit (21) générateur de stimuli, mémorisant le programme de test, une interface (11) de traduction des stimuli d'un langage élaboré vers un langage de bas niveau correspondant à celui du modèle logiciel, et des moyens de validation de la vérification en cas de détection de collision par le comparateur (23).

17. Plate-forme de vérification selon une des revendications 7 à 16, **caractérisée en ce que** les moyens de sélection de la réponse à des stimuli dépendants de la constitution des circuits testés sont constitués d'un modèle élaboré grâce à des moyens de sélection, parmi une bibliothèque, de modèles fonctionnels associant, à chacun des modèles, les réponses à un stimulus donné, le modèle correspondant à la constitution du circuit à tester.

18. Plate-forme de vérification selon une des revendications 7 à 17, **caractérisée en ce qu'**elle comporte des moyens (7) de mémorisation des réponses ainsi sélectionnées pour constituer un modèle de test (70) à appliquer au circuit testé lors de la réception de stimuli.

19. Plate-forme de vérification selon une des revendications 7 à 18, **caractérisée en ce que** chaque transaction est constituée, au niveau de chaque interface, d'un paquet requête et d'un ou plusieurs paquets réponses associés, dont les valeurs des paramètres et/ou les contraintes temporelles d'émission des paquets peuvent être forcées à partir du programme de test fonctionnel exécuté par l'émulateur de l'environnement, qui traduit de façon adéquate l'ensemble de ces paramètres lors de l'émission des paquets aux bornes du modèle logiciel du projet.

20. Plate-forme de vérification selon la revendication 14, **caractérisée en ce que** la génération des prédictions est effectuée par l'émulateur du circuit sans avoir à prélever d'informations supplémentaires sur le fonctionnement interne du circuit en projet.
